# EUROPÄISCHE PATENTSCHRIFT

(11) **EP 0 383 357 B1**
(45) Veröffentlichungstag und Bekanntmachung des Hinweises auf die Patenterteilung: **13.07.1994**
(21) Anmeldenummer: 90103147.6
(22) Anmeldetag: 19.02.1990
(51) Int. Cl.: H05K 7/14

(54) **Geräterückwand für elektrische und/oder elektronische Geräte**
Rear panel for electrical and/or electronic apparatuses
Panneau arrière d'appareil pour appareil électrique et/ou électronique

(30) Priorität: 17.02.1989 DE 3904935; 07.03.1989 DE 3907278
(43) Veröffentlichungstag der Anmeldung: 22.08.1990
(73) Patentinhaber: Siemens Nixdorf Informationssysteme Aktiengesellschaft, 33102 Paderborn (DE)
(72) Erfinder: Lerch, Peter, Dipl.-Ing., D-4790 Paderborn (DE); Niemeier, Hubert, Dr.Ing., D-4790 Paderborn (DE); Flotho, Helmut, D-4798 Fürstenberg (DE); Neumann, Gerd, D-4790 Paderborn (DE)
(74) Vertreter: Fuchs, Franz-Josef, Dr.-Ing.

(56) Entgegenhaltungen:
- EP-A- 0 220 677
- EP-A- 0 236 799
- EP-A- 0 282 637
- DE-A- 3 604 860

## Beschreibung

Die Erfindung betrifft eine Geräterückwand der im Oberbegriff des Anspruchs 1 genannten Art.

Gattungsgemäße elektronische Geräte sind aus EP-A-0 282 637 bekannt.

Ein typisches Anwendungsbeispiel für eine derartige Gerätewand ist die Anschlußrückwand eines zentralen Rechners, an welchen mehrere periphere Arbeitsplätze (Teilnehmer) angeschlossen werden können. Dabei werden über die Steckverbinder im allgemeinen Signale mit großer Bandbreite übertragen, so daß diese Steckverbinder in aufwendiger und teurer Weise HF-dicht und EMV-gesichert ausgeführt sein müssen. Besondere Probleme enstehen dann, wenn nur ein Teil der maximal möglichen Teilnahmeranzahl angeschlossen werden soll. Vor allem dann, wenn viele unterschiedliche Steckverbinder je Teilnehmer erforderlich sind, ist es aus Kostengründen nicht sinnvoll, schon bei der Basisaustattung (Anzahl der angeschlossenen Teilnehmer kleiner als die maximal mögliche Anzahl) alle Teilnehmeranschlußmöglichkeiten zur Verfügung zu stellen, da dann ein Teil der teuren Steckverbinder nutzlos ist und lediglich den Preis des Gerätes über das erforderliche Maß hinaus erhöht. Außerdem muß zusätzlich dafür Sorge getragen werden, daß die nichtbelegten Steckverbinder durch gesonderte Blindstecker oder dergleichen HF-dicht verschlossen werden, um ein Ein- oder Austreten von Störstrahlung durch diese Steckverbinder zu vehindern. Dadurch wird das Gerät weiter verteuert.

Bei Geräten der im Oberbegriff des Anspruchs 1 genannten Art versucht man, die Verbindung von den elektronischen Modulen des Gerätes zu den Steckverbindern möglichst kurz zu halten, um die Leitungsführung zu vereinfachen und um die interne Störstrahlung möglichst gering zu halten. Das führt im allgemeinen zu einer Konstruktion mit einer als Leiterplatte ausgebildeten "Rückwand", in die einerseits die elektronischen Module gesteckt werden können und auf der andererseits das Steckverbinderfeld montiert ist. Ein Nachteil einer derartigen Anordnung ist, daß die zum Teil erheblichen, auf die HF-dichten Steckverbinder wirkenden Steckkräfte beim Ein- und Ausstecken der Anschlußsteckverbinder der peripheren Geräte diese Rückwand-Leiterplatte belasten.

Es ist die Aufgabe der vorliegenden Erfindung, eine Geräterückwand der im Oberbegriff des Anspruchs 1 genannten Art zu schaffen, die einerseits in einfacher und kostensparender Weise an die Zahl der jeweils anzuschließenden Teilnehmer angepaßt und im übrigen HF-dicht abgeschlossen werden kann und bei der die das Steckverbinderfeld tragende Wand von hohen Steckkräften freigehalten wird.

Diese Aufgabe ist erfindungsgemäß durch die im Kennzeichen des Anspruchs 1 genannten Merkmale gelöst.

Durch die Ausbildung der Geräterückwand als Doppelwand besteht die Möglichkeit, auf der Innenwand ein Steckverbinderfeld mit einfachen Steckverbindern anzuordnen, an die keine hohen Anforderungen hinsichtlich EMV-Sicherheit gestellt werden müssen. Da derartige Steckverbinder preiswert sind, kann ohne großen Kostenaufwand die maximale Anzahl von Teilnehmeranschlüssen vorgesehen sein.

Die Außenwand wird aus mehreren Wandelementen zusammengesetzt, von denen in Abhängigkeit von der Anzahl der vorgesehenen Anschlußmöglichkeiten eines oder mehrere mit Steckverbindern bestückt und die jeweils anderen leer sind; nur die auf den Wandelementen der Außenwand vorgesehenen Steckverbinder müssen die Bedingungen hinsichtlich eines HF-dichten Anschlusses erfüllen, so daß die Zahl der teuren Steckverbinder auf die Zahl der vorgesehenen Anschlüsse beschränkt bleibt. Durch die leeren Wandelemente wird die Außenwand zu einer geschlossenen Wand ergänzt. Nicht belegte und damit EMV-ungesicherte Steckverbinder gibt es damit in der Außenwand nicht, so daß auch der Aufwand für das Montieren von Blindsteckern oder dergleichen entfallen kann.

Außerdem werden die beim Ein- und Ausstecken von HF-dichten Steckverbindern auftretenden hohen Steckkräfte von den Wandelementen der Außenwand aufgenommen, die konstruktiv an diese Aufgabe angepaßt und mit der Seitenwandstruktur des Gerätes verbunden sind. Die das Feld mit den einfachen, nicht HF-dichten Steckverbindern tragende Innenwand bleibt von hohen Steckkräften frei. Das ist vor allem dann von Vorteil, wenn die Innenwand selbst als Leiterplatte ausgebildet ist, auf deren dem Gehäuseinneren zugewandten Seite Tochterplatten aufsteckbar sind.

Es hat sich gezeigt, daß bei den im Mittel gewünschten Basisausstattungen von Geräten der im Oberbegriff des Anspruches 1 genannten Art die Zusatzkosten durch die doppelwandige Ausbildung der Gerätewand geringer als die erzielbaren Einsparungen durch die kleinere Zahl von HF-dichten Steckverbindern ist. Durch die erfindungsgemäße Ausbildung ergibt sich außerdem der Vorteil, daß die an der Außenwand angeordneten Steckverbinder in einfacher Weise an verschiedene Normen unterschiedlicher Länder, an bestimmte Anschlußpolkonfigurationen usw. angepaßt werden können, ohne daß dazu das Steckverbinderfeld der Innenwand geändert werden müßte. Dieses kann vielmehr einen Standardaufbau haben, wobei der Übergang vom Steckverbinderfeld der Innenwand zu den Steckverbindern der Außenwand durch entsprechende Adapter hergestellt wird.

Gemäß einer Ausgestaltung der Erfindung sind die Wandelemente mit Mitteln zur lösbaren Befestigung am Gerät ausgestattet. Die Außenwand kann deshalb jederzeit in einfacher Weise entsprechend der vorgesehenen Anzahl von Anschlüssen aus- bzw. auch umgerüstet werden, indem z.B. leere Wandelemente gegen mit Steckverbindern ausgestattete Wandelemente ausgetauscht werden und die neuen Wandelemente mittels der Steckverbinder mit der Innenwand elektrisch verbunden werden. Diese Umrüstung kann auch von nicht speziell dafür geschultem Personal durchgeführt werden.

Die Verbindung zwischen den Steckverbindern der Innenwand und der Außenwand kann jeweils mittels einer beliebig aufgebauten Übergabeschaltungsanordnung hergestellt werden, zum Beispiel über mit entsprechenden Gegensteckverbindern ausgestattete Kabel; in einer bevorzugten Ausgestaltung der Erfindung ist jedoch vorgesehen, daß die mit Steckverbindern versehenen "aktiven" Wandelemente jeweils auf ihrer der Innenwand zugewandten Innenfläche eine von dieser abstehende Überbrückungsplatte tragen, an deren der Innenwand zugewandter Innenkante mit Steckverbindern der Innenwand zusammenwirkende Anschlußsteckverbinder angeordnet sind, und daß auf der Überbrückungsplatte eine Schaltungsanordnung zum elektrischen Verbinden der Anschlußsteckverbinder mit den äußeren Steckverbindern der Wandelemente ausgebildet sind. Bei der Montage der aktiven Wandelemente werden diese gleichzeitig mit den Steckverbindern der Innenwand gekuppelt und brauchen dann nur noch am Wandelementträger des Gerätes befestigt zu werden.

Die Überbrückungsplatten können jeweils wenigstens einen Steckplatz zum Stecken eines auswechselbaren Schaltungsbauelementes haben, so daß die Übergabeschaltungsanordnung flexibel an die jeweiligen Aufgaben angepaßt werden kann.

In einer anderen Ausgestaltung der Erfindung ist vorgesehen, daß auf der Überbrückungsplatte außer den Leiterbahnen zur Verbindung der Anschlußsteckverbinder mit den Steckverbindern der Wandelemente eine Konvertierungselektronikschaltung angeordent ist. Damit kann beispielsweise eine Normanpassung von den an der Innenwand anliegenden Signalnormen an unterschiedliche Normen durchgeführt werden, die dann an der Außenwand abgenommen werden kann. Dies ist besonders für unterschiedliche Auslandsvarianten vorteilhaft, bei denen von der Basisversion des Gerätes abweichende Normen erfüllt werden müssen. Damit können kostenintensive Normanpassungen auf den Tochterkarten des Gerätes entfallen.

Damit die aus einzelnen Wandelementen gebildete Außenwand HF-dicht ist, müssen die Wandelemente gegeneinander abgedichtet sein. Dazu können beispielsweise die Ränder der Wandelemente so profiliert sein, daß sie jeweils abdichtend in die Ränder angrenzender Wandelemente eingreifen. Gemäß einer bevorzugten Ausgestaltung der Erfindung ist jedoch vorgesehen, daß entlang zumindest einzelner, an benachbarten Wandelementen anliegender Ränder der Wandelemente gesonderte Dichtungselemente angeordnet sind. Die Dichtungselemente sind vorzugsweise jeweils als ein parallel zum zugeordneten Rand des Wandelementes angeordneter, über diesen Rand nach außen überstehender Federblechstreifen ausgebildet. Bei der Montage der Wandelemente legen sich die Federblechstreifen benachbarter Wandelemente federnd gegeneinander.

Gemäß einer weiteren Ausgestaltung der Erfindung sind die einzelnen Wandelemente über Masse-Kontaktelemente elektrisch leitend miteinander verbunden, die die Abschirmwirkung der aus den Wandelementen zusammengesetzten Außenwand auch über die Trennfugen zwischen den Wandelementen Einweg sicherstellt.

Die Wandelemente sind vorzugsweise als rechteckige, mit ihren Längsrändern aneinanderliegende Platinen ausgebildet und liegen mit ihren kurzen Querrändern auf einem Wandelementträger des Gerätes, der ein Teil der Seitenwandstruktur ist, auf.

Mehrere Ausführungsbeispiele der Erfindung sind in der Zeichnung dargestellt und im folgenden näher beschrieben. Es zeigen:
- Fig. 1: schematisch ein Gerätegehäuse mit einer doppelwandigen Geräterückwand in perspektivischer Darstellung;
- Fig. 2: einen Teil einer Gerätegehäuserückwand etwa gemäß Fig. 1;
- Fig. 3: einen Querschnitt durch ein Gerätegehäuse entsprechend der Schnittlinie III-III in Fig. 2;
- Fig. 4: ein mit Steckverbindern ausgestattetes Wandelement für ein Gerätegehäuse gemäß den Fig. 2 oder 3 in perspektivischer Darstellung;
- Fig. 5: einen Längsschnitt durch ein Gerätegehäuse entlang der Schnittlinie V-V in Fig. 3.
- Fig. 6: eine schematische Teilansicht der Rückseite eines Gehäusechassis eines im übrigen nicht dargestellten Datenverarbeitungsgerätes,
- Fig. 7: eine schematische Draufsicht auf den rückwärtigen Abschnitt eines Gerätechassis,
- Fig. 8: eine perspektivische schematische Darstellung eines Wandelementes mit einer eine Übergabeschaltung tragenden Überbrückungsplatte,
- Fig. 9: eine der Fig. 8 entsprechende Darstellung eines Wandelementes mit Flachbandkabelverbindungen,
- Fig. 10: eine perspektivische Teildarstellung einer Seitenfläche eines Wandelementes gemäß den Fig. 8 und 9 mit einer zugehörigen Kontaktleiste,
- Fig. 11: einen Längsschnitt durch die in der Fig. 10 dargestellte Seitenfläche mit angenieteter Kontaktleiste,
- Fig. 12: eine Draufsicht auf eine zweite Ausführungsform einer Seitenfläche eines Wandelementes,
- Fig. 13: eine Draufsicht auf das mit A bezeichnete Detail aus Fig. 12 und
- Fig. 14: einen Schnitt längs Linie IX-IX in Fig. 13.

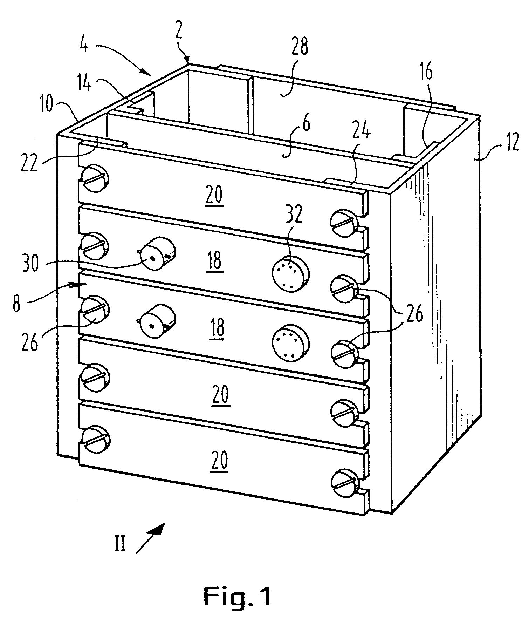

Fig. 1 zeigt das Gehäuse 2 eines elektronischen Gerätes 4, beispielsweise eines elektronischen Rechners. Das Gerät 4 weist eine Geräterückwand auf, die als Doppelwand mit einer Innenwand 6 und einer Außenwand 8 ausgebildet ist. Die Innenwand 6 und die Außenwand 8 haben einen Abstand zueinander und sind im wesentlichen zueinander parallel angeordnet. Die Innenwand 6 und die Außenwand 8 sind an Seitenwandstrukturen des Gerätegehäuses befestigt. Im Beispiel gemäß der Fig. 1 stehen quer zu den Ebenen der Innenwand 6 bzw. der Außenwand 8 seitliche Anschlußwände 10 bzw. 12. Die Innenwand 6 ist über Winkel 14, 16 zwischen den Anschlußwänden 10, 12 befestigt. Die Außenwand 8 besteht aus mehreren Wandelementen 18 bzw. 20. Diese sind auf in die Ebene der Außenwand 8 abgebogene Randstreifen 22, 24 der Anschlußwände 10 bzw. 12 aufgelegt und mit diesen über Schrauben 26 verschraubt. An der Vorderseite des Gehäuses 2 ist ebenfalls auf abgebogenen Randstreifen der Anschlußwände 10, 12 eine Vorderwand 28 befestigt; im betriebsfertigen Zustand ist das Gehäuse oben und unten durch eine Deckenplatte bzw. Bodenplatte verschlossen, wie hier nicht dargestellt wurde.

Wie Fig. 1 erkennen läßt, sind die Wandelemente 18, 20 als rechteckige, mit ihren Längsrändern wenigstens annähernd aneinanderliegende Platinen ausgebildet. Die Wandelemente 18 sind mit Steckverbindern 30, 32 unterschiedlichen Typs ausgestattet, die mit Steckverbindern eines Steckverbinderfeldes auf der Innenwand 6 verbunden werden können, wie weiter hinten genauer dargestellt wird. Die Wandelemente 20 sind sogenannte leere Wandelemente ohne Steckverbinder.

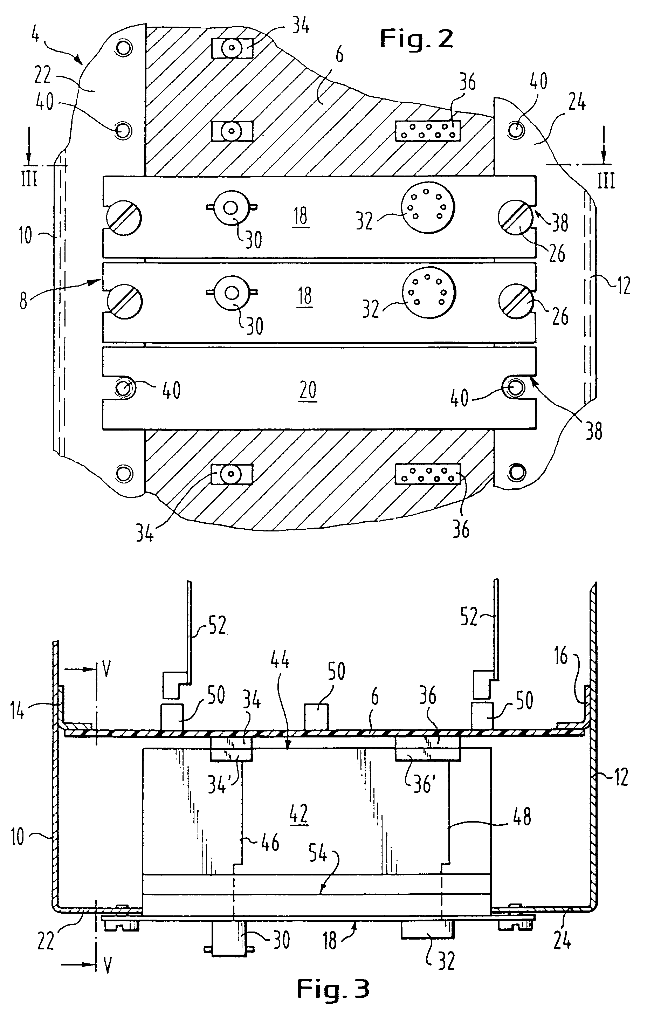

Fig. 2 zeigt eine Ansicht eines Gerätegehäuses der in Fig. 1 dargestellten Art in Richtung des Pfeiles II. Die Innenwand 6 ist schraffiert dargestellt. Sie trägt ein Steckverbinderfeld mit Steckverbindern 34, 36 unterschiedlichen Typs. Ein Paar nebeneinander angeordneter Steckverbinder 34 bzw. 36 ist beispielsweise jeweils für den Anschluß eines periphe-ren Gerätes an das Gerät 4 bestimmt. Da die Steckverbinder 34, 36 nicht unmittelbar nach außerhalb des Gerätes münden, sondern durch die Außenwand 8 abgedeckt sind, müssen sie keine hohe Anforderungen hinsichlich einer EMV-Sicherheit erfüllen; sie können deshalb von einfacher, preisgünstiger Art sein. Sie können deshalb in einer Anzahl vorhanden sein, die für den Anschluß der maximal zulässigen Peripheriegeräteanzahl ausreichend ist.

Die mit Steckverbindern 30, 32 ausgestatteten Wandelemente 18 sind nur in einer solchen Anzahl vorgesehen, die der Anzahl der tatsächlich anzuschließenden Peripheriegeräte entspricht. Außerdem sind leere Wandelemente 20 vorgesehen, die die Rückwand 8 in der bereits anhand der Fig. 1 beschriebenen Weise zu einer geschlossenen Wandfläche ergänzen. Die Wandelemente 18, 20 liegen jeweils mit ihren Längsrändern an benachbarten Wandelementen an und liegen mit ihren kurzen Querrändern auf einander gegenüberliegenden Randstreifen 22, 24 der seitlichen Anschlußwände 10, 12 auf, wie auch aus Fig. 3 erkennbar ist. Die Wandelemente 18 und 20 sind an ihren kurzen Querrändern jeweils mit schlitzartigen Öffnungen 38 versehen, durch die Schrauben 26 hindurchgreifen, die in Schrauböffnungen 40 in den Randstreifen 22 bzw. 24 einschraubbar sind.

Wie die Fig. 3, 4 und 5 erkennen lassen, tragen die mit Steckverbindern 30, 32 versehenen Wandelemente 18 jeweils auf ihrer der Innenwand 6 zugewandten Innenfläche eine von dieser abstehende Überbrückungsplatte 42, an deren der Innenwand 6 zugewandter Endkante 44 mit den Steckverbindern 34, 36 zusammenwirkende Anschlußsteckverbinder 34′, 36′ angeordnet sind; auf den Überbrückungsplatten 42 sind Leiterbahnen 46, 48 ausgebildet, die die Anschlußsteckverbinder 34′, 36′ mit den Steckverbindern 30, 32 des Wandelementes 18 verbinden. Beim Montieren der Leiterplatte 18 werden die Anschlußsteckverbinder 34′, 36′ mit den zugeordneten Steckverbindern 34, 36 der Innenwand 6 gekuppelt, so daß über die Leiterbahnen 46, 48 und die Steckverbinder 30, 32 Peripheriegeräte anschließbar sind. Mit 60 ist eine Elektronikschaltung bezeichnet, die die an den Steckverbindern 30, 32 anliegenden Signale konvertiert, nämlich beispielsweise an eine für andere Länder geltende Norm anpaßt, so daß ohne Änderung des Gerätes und insbesondere der darin enthaltenen Tochterkarten diese Norm an den Steckverbindern 34′, 36′ abgenommen werden kann. Die Elektronikschaltung 60 kann z.B. Signalpegel ändern oder neue Signale erzeugen, indem beispielsweise mehrere vorhandene Signale summiert werden.

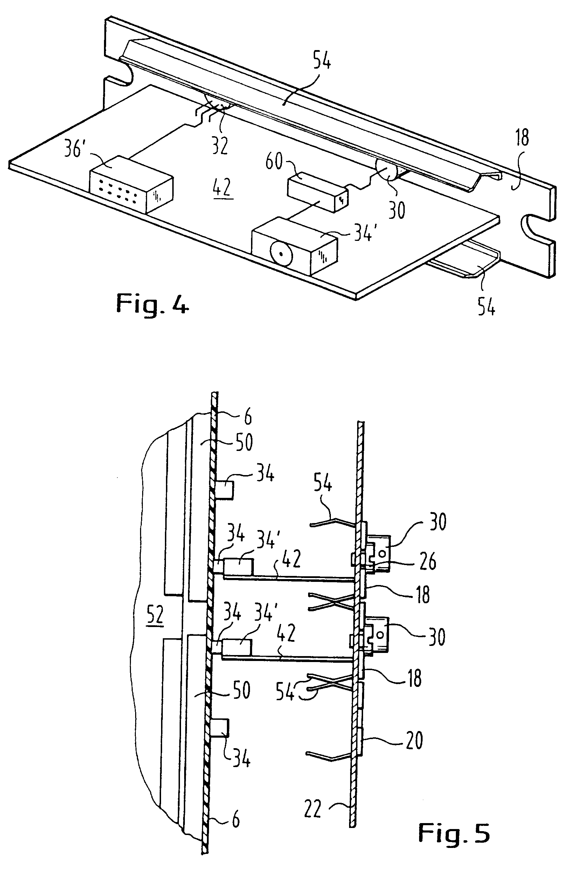

Fig. 3 und 5 zeigen, daß die Innenwand 6 als Leiterplatte ausgebildet ist, auf deren dem Geräteinneren zugewandten Seite über Steckerleisten 50 Tochterkarten 52 anschließbar sind.

Um die Wandelemente 18, 20 an ihren aneinanderliegenden Längsrändern HF-dicht zu machen, sind entlang ihren Längsrändern Dichtelemente 54 angeordnet. Diese Dichtelemente bestehen aus profilierten Federblechstreifen, die nach außen etwas über die Längsränder der Wandelemente 18 bzw. 20 überstehen. Bei der Montage der Wandelemente 18 bzw. 20 legen sich die Dichtelemente 54 je zweier benachbarter Wandelemente federnd gegeneinander, wie insbesondere Fig. 5 zeigt, und bewirken einen HF-dichten Anschluß der Wandelemente 18 bzw. 20 aneinander.

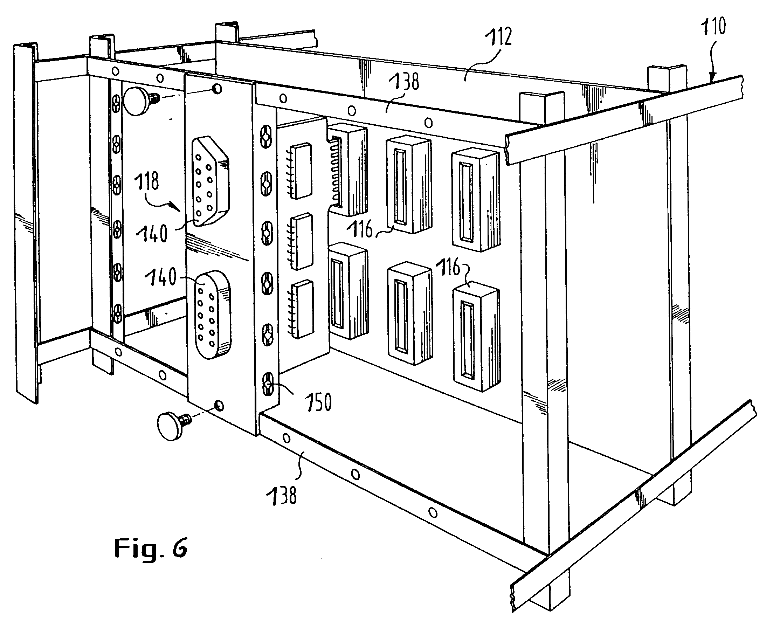

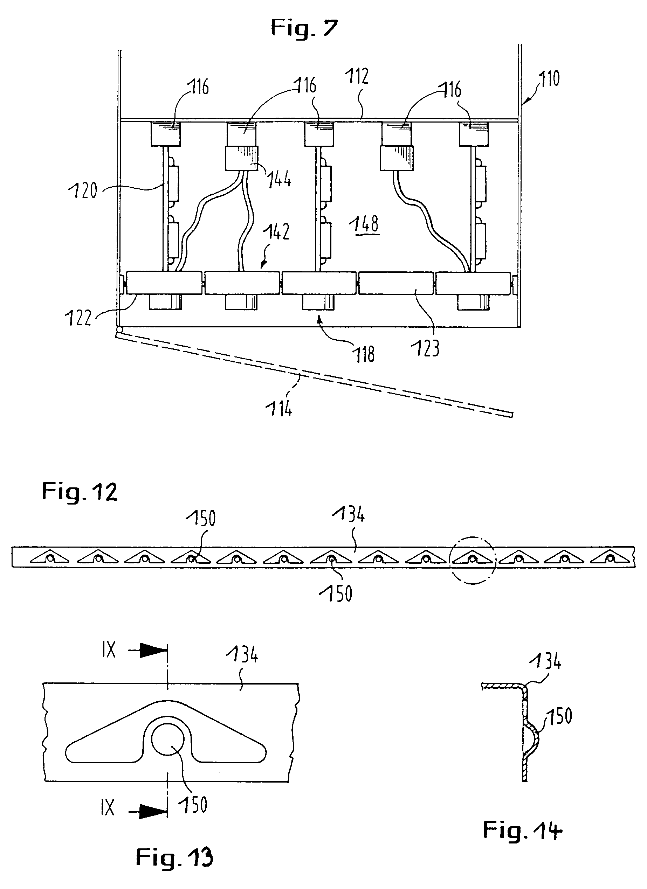

In Fig. 6 ist mit 110 ein Teil eines Chassis eines Gerätegehäuses eines im übrigen nicht dargestellten Datenverarbeitungsgerätes bezeichnet. Das eigentliche Datenverarbeitungsgerät ist durch eine Innenwand 112 abgeschlossen. Das Chassis selber ist durch metallische Seitenwände, einen Boden und eine Deckfläche verkleidet. Der sich an die Innenwand 112 zum Betrachter hin anschließende Raum ist durch eine Klapptür 114 verschlossen (Fig. 7).

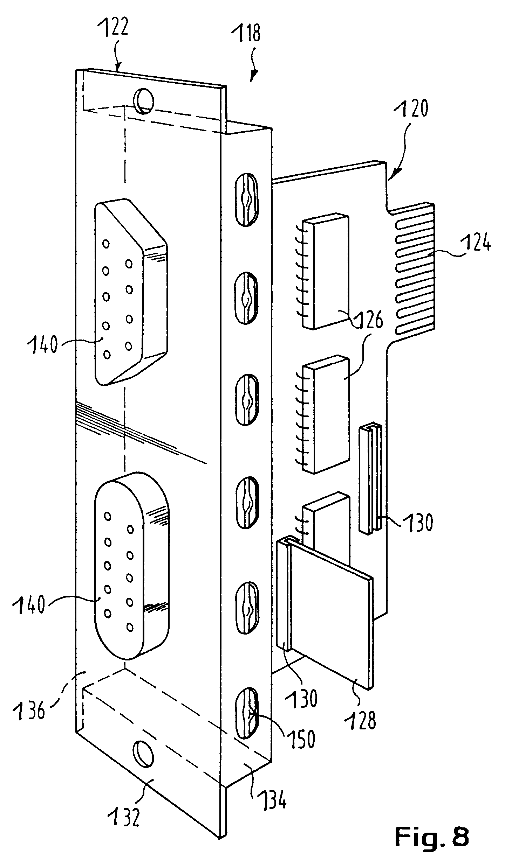

Die Innenwand 112 trägt ein Steckerverbinderfeld mit verschiedenen Steckeranordnungen 116, die zur Verbindung des Datenverarbeitungsgerätes mit nicht dargestellten Peripheriegeräten dienen und unterschiedlich ausgebildet sein können. Wenn es erforderlich ist, die zwischen dem Datenverarbeltungsgerät und dem jeweiligen Peripheriegerät ausgetauschten Signale an das jeweilige Peripherigerät anzupassen, z.B. bei unterschiedlichen Drucker, Dann erfolgt diese Anpassung jeweils durch ein Übergabesystem mit den Peripheriegeräten entsprechenden Übergabestrecken. Die Übergabestrecken sind als austauschbare Schnittstellen ausgebildet, so daß bei unterschiedlichen Peripherigeräten die für das jeweilige Peripheriegerät geeignete Schnittstelle eingesetzt werden kann. In den Fig. 6 und 8 ist eine allgemein mit 118 bezeichnete Anordnung dargestellt, die im wesentlichen eine aus einer Überbrückungsplatte mit aufgedruckter Schaltung gebildete Schaltungsplatine 120 und ein Wandelement 122 umfaßt. Die Schaltungsplatine 120 ist mit einer Steckleiste 124 in einen der Stecker 116 an der Innenwand 112 des Datenverarbeitungsgerätes einsteckbar. Die elektronische Schaltung auf der Schaltungsplatine 120 ist lediglich durch einige Bauelemente 126 angedeutet. Dabei kann die elektronische Schaltung auf der Platine 120 wiederum durch steckbare Bauelemente oder Bauelementengruppen 128 modifizierbar sein, die in Stekkerleisten 130 einsteckbar sind.

Das Wandelement 122 besteht aus einer metallischen Platte 132, an deren Längsseiten senkrecht zu ihr gerichtete Stege 134 und 136 angeordnet sind. Die Größe der Platte 132 ist so gewählt, daß sie mit ihren Schmalseiten jeweils an einer Traverse 138 des Chassis 110 angeschraubt werden kann, wie dies in Fig. 6 angedeutet ist. Die Platte 132 trägt ferner äußere Stecker 140, die zur Verbindung mit dem jeweils zugehörigen Peripheriegerät bestimmt sind.

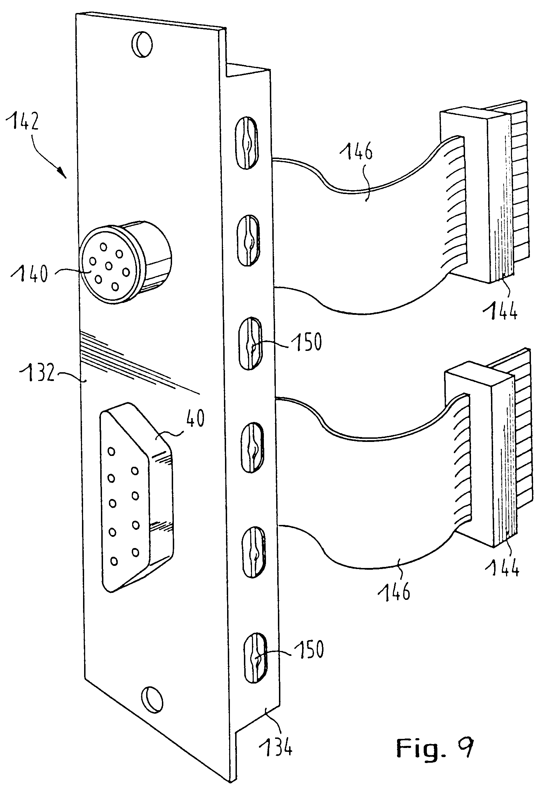

Fig. 9 zeigt eine weitere Anordnung 142, bei der gleiche Elemente wieder mit gleichen Bezugszeichen versehen sind. Diese unterscheidet sich von der Anordnung 118 dadurch, daß sie keine Schaltungsplatine aufweist, sondern daß die Verbindung zwischen den äußeren Steckern 140 und inneren Steckern 144 durch Flachbandkabel 146 erfolgt. Die inneren Stecker 144 können wieder in die Stecker 116 an der Innenwand 112 eingesteckt werden. Die Abmessungen der Wandelemente 132 sind so gewählt, daß bei der Montage mehrerer Anordnungen 118 und/oder 142 nebeneinander in der in Fig. 7 ersichtlichen Weise eine geschlossene Außenwand entsteht, welche den zwischen ihr und der Rückwand 112 eingeschlossenen Übergaberaum 148 begrenzt. Sind weniger Anordnungen 118, 142 vorhanden, als in den Übergaberaum 148 eingebaut werden könnten, so wird die aus den Wandelementen 122 der Anordnungen 118, 142 aufgebaute Wand durch ein Blindelement in Form einer Blende 123 allein geschlossen, wie dies in Fig. 7 dargestellt ist.

Um einen leitenden Kontakt zwischen den Wandelementen 122 der einzelnen Anordnungen 118, 142 zu ermöglichen und damit eine Abschirmwirkung der aus den Wandelementen 122 gebildeten Außenwand zu gewährleisten, trägt bei jedem Wandelement 122 der Steg 134 Masse-Kontaktelemente 150, die im eingebauten Zustand der Anordnungen 118, 142 zur Anlage an dem Steg 136 eines benachbarten Wandelementes 122 bestimmt sind.

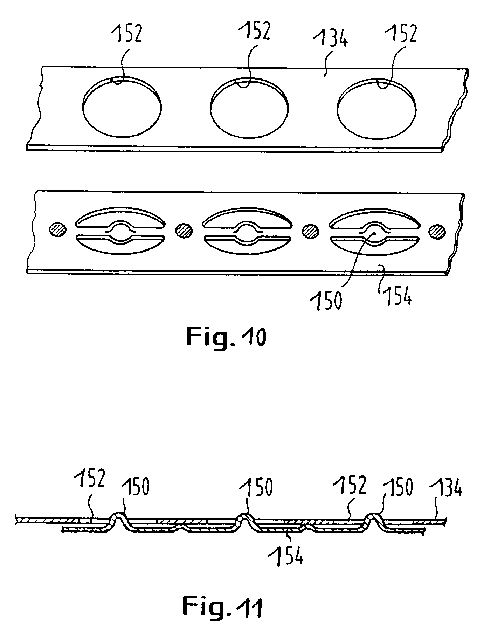

Der Aufbau der so gebildeten Kontaktleiste kann dabei entsprechend der Fig. 10 und 11 in der Weise erfolgen, daß der Steg 134 Öffnungen 152 aufweist und mit einer Federkontaktleiste 154 so vernietet wird, daß an der Federkontaktleiste 154 ausgebildete Kontaktelemente 150 durch die Öffnungen 152 hindurchragen, wie man dies in Fig. 11 erkennt. Die Kontaktelemente 150 haben auf diese Weise genügend Spiel, um federnd an dem Steg 136 einer benachbarten Anordnung 118, 142 anzuliegen.

Die Fig. 12 bis 14 zeigen eine Ausführungsform, bei der die Kontaktelemente 150 einstückig mit dem Steg 134 ausgebildet sind, wobei vorausgesetzt wird, daß die gesamte Blende aus einem federelastischen Material besteht.

Die aus den Wandelementen 122 der einzelnen Anordnungen 118, 142 bzw. aus blinden Wandelementen gebildete Fläche ermöglicht es aufgrund ihrer Abschirmwirkung, gegebenenfalls auf die Gehäusetür 114 zu verzichten.

Die vorliegend beschriebene Übergabeanordnung ermöglicht es, auf einfache Weise und ohne spezielle Fachkenntnisse Schnittstellen, welche die Signalanpassung in der Verbindung zwischen dem Datenverarbeitungsgerät und einem Peripheriegerät vornehmen, auszuwechseln, wobei stets für eine gute Abschirmung der Übergabestrekken gesorgt ist.

## Patentansprüche

1. Geräterückwand (6, 8) für elektrische und/oder elektronische Geräte (4), mit einem Steckverbinderfeld für die äußere Beschaltung des Gerätes, wobei die Geräterückwand mit Seitenwandstrukturen (10, 12) des Gerätes fest verbunden ist, dadurch **gekennzeichnet**,
- daß die Gerätewand als Doppelwand mit einer Innenwand (6) und einer dazu mit einem Abstand angeordneten Außenwand (8) ausgebildet ist,
- daß die Innenwand (6) ein den Anschlußmöglichkeiten des Gerätes entsprechendes Steckverbinderfeld (34, 36) trägt,
- daß die Außenwand aus mehreren, eine geschlossene Wandfläche bildenden, mit den Seitenwandstrukturen (10, 12) verbundenen Wandelementen (18, 20; 122) zusammengesetzt ist, von denen mindestens eines mit einem oder mehreren äußeren Steckverbindern (30, 32) für äußere Beschaltungsanschlüsse versehen ist, wobei die Steckverbinder (30, 32) jeweils mittels einer Übergabeschaltungsanordnung (42) mit dem Steckverbinderfeld (34, 36) verbunden sind.

2. Geräterückwand nach Anspruch 1, dadurch **gekennzeichnet**, daß die Wandelemente (18, 20; 122) lösbar mit den Seitenwandstrukturen (10, 12) verbunden sind.

3. Geräterückwand nach Anspruch 1 oder 2, dadurch **gekennzeichnet**, daß die Übergabeschaltungsanordnung eine auf der Innenseite eines Wandelementes (18) im wesentlichen rechtwinklig angeordnete Überbrückungsplatte (42) umfaßt, an deren der Innenwand (6) zugewandter Endkante (44) mit Steckverbindern (34, 36) des Steckverbinderfeldes zusammenwirkende Anschlußsteckverbinder (34′, 36′) angeordnet sind, und daß auf der Überbrückungsplatte (42) eine die Anschlußsteckverbinder (34′, 36′) mit den äußeren Steckverbindern (30, 32) verbindende Schaltungsanordnung (46, 60) ausgebildet ist.

4. Geräterückwand nach Anspruch 3, dadurch **gekennzeichnet**, daß die Überbrückungsplatten (42) jeweils wenigstens einen Steckplatz für ein auswechselbares Schaltungsbauelement oder eine Schaltungsbauelementengruppe trägt.

5. Geräterückwand nach einem der Ansprüche 3 oder 4, dadurch **gekennzeichnet**, daß auf den Überbrückungsplatten (42) jeweils eine Elektronikschaltungsanordnung (60) zum Konvertieren der an den Steckverbindern (34, 36) des Steckverbinderfeldes anliegenden Signale und zum Ausgeben der konvertierten Signale an die äußeren Steckverbinder (30, 32) der Wandelemente (18) ausgebildet ist.

6. Geräterückwand nach einem der Ansprüche 1 bis 5, dadurch **gekennzeichnet**, daß entlang zumindest einzelner an Rändern benachbarter Wandelemente anliegender Ränder der Wandelemente (18, 20) Dichtungselemente (54) für einen HF-dichten Anschluß aneinander angrenzender Wandelemente (18, 20) angeordnet sind.

7. Geräterückwand nach Anspruch 6, dadurch **gekennzeichnet**, daß die Dichtungselemente (54) jeweils als parallel zum zugeordneten Rand des Wandelementes (18, 20) angeordnete, über den Rand nach außen überstehende Federblechstreifen ausgebildet sind.

8. Geräterückwand nach einem der Ansprüche 1 bis 5, dadurch **gekennzeichnet**, daß die einzelnen Wandelemente (18, 20; 122) über Masse-Kontaktelemente (150) elektrisch leitend miteinander verbunden sind.

9. Geräterückwand nach Anspruch 8, dadurch **gekennzeichnet**, daß die Masse-Kontaktelemente (150) an einander zugekehrten Flächen (134) benachbarter Wandelemente (122) ausgeformt sind.

10. Geräterückwand nach einem der Ansprüche 1 bis 9, dadurch **gekennzeichnet**, daß die Seitenwandstrukturen (10, 12) wenigstens zwei im wesentlichen in der Ebene der Außenwand (8) liegende, parallel und mit Abstand zueinander angeordnete Auflageflächen (22, 24) bilden, auf denen die mit Längsrändern aneinandergrenzenden Wandelemente (18, 20) mit ihren Querrändern aufgelegt und befestigt werden.

## Claims

1. Apparatus rear panel (6, 8) for electrical and/or electronic apparatuses (4), having a plug-connector section for the external wiring of the apparatus, the apparatus rear panel being firmly connected to side panel structures (10, 12) of the apparatus, characterized in that
- the apparatus panel is constructed as a double panel having an inner panel (6) and an outer panel (8) arranged at a distance from said inner panel,
- the inner panel (6) supports a plug-connector section (34, 36) corresponding to the connection capabilities of the apparatus,
- the outer panel is composed of a plurality of panel elements (18, 20; 122) connected to the side panel structures (10, 12) and forming a closed panel surface, of which at least one wall panel is provided with one or more external plug connectors (30, 32) for external wiring connections, the plug connectors (30, 32) in each case being connected to the plug-connector section by means of an adapter circuit arrangement.

2. Apparatus rear panel according to Claim 1, characterized in that the wall elements (18, 20; 122) are detachably connected to the side panel structures (10, 12).

3. Apparatus rear panel according to Claim 1 or 2, characterized in that the adapter circuit arrangement comprises a jumper board (42) which is arranged on the inside of a panel element (18) substantially at right angles, and on whose end edge (44) facing the inner panel cable connectors (34', 36') interacting with the plug connectors (34, 36) of the plug-connector section are arranged, and in that a circuit arrangement (46, 60) connecting the cable connectors (34', 36') to the external outer plug connectors (30, 32) is constructed on the jumper boards (42).

4. Apparatus rear panel according to Claim 3, characterized in that the jumper boards (42) in each case have at least one slot for a replaceable circuit component or a group of circuit components.

5. Apparatus rear panel according to one of Claims 3 or 4, characterized in that in each case one electronic circuit arrangement (60) is constructed on the jumper boards (42), for converting the signals present on the plug connectors (34, 36) of the plug-connector section and for outputing the converted signals to the external plug connectors (30, 32) of the panel elements (18).

6. Apparatus rear panel according to one of Claims 1 to 5, characterized in that sealing elements (54) are arranged alongside at least some of the edges resting on edges of neighbouring panel elements (54), for RF-tight connection of mutually adjacent panel elements (18, 20).

7. Apparatus rear panel according to Claim 6, characterized in that the sealing elements (54) are in case constructed as spring-steel sheet strips, which are in each case arranged parallel to the corresponding edge of the panel element (18, 20) and protruding outwards beyond the edge.

8. Apparatus rear panel according to one of Claims 1 to 5, characterized in that the individual panel elements (18, 20; 122) are connected in an electrically conductive manner via earth contact elements (150).

9. Apparatus rear panel according to Claim 8, characterized in that the earth contact elements (150) are formed on surfaces facing each other of neighbouring panel elements (122).

10. Apparatus rear panel according to one of Claims 1 to 9, characterized in that the side panel structures (10, 12) form at least two support surfaces (22, 24) lying substantially in the plane of the outer panel (8) and arranged parallel and at a distance from one another, on which surfaces the transverse edges of the panel elements (18, 20) bordering onto each other with their longitudinal edges are placed and fastened.

## Revendications

1. Paroi arrière (6, 8) pour appareils électriques et électroniques comportant une plage de connecteurs à enfichage, destinée au branchement extérieur de l'appareil, la paroi arrière de l'appareil étant reliée de façon solide aux structures de parois latérales (10, 12) de l'appareil,
caractérisée en ce que
la paroi de l'appareil a une conformation de paroi double, comportant une paroi intérieure (6) et une paroi extérieure disposée à une certaine distance de celle-ci,
- en ce que la paroi intérieure (6) possèdee une plage (34, 36) de connecteurs pour des possibilités de branchement de l'appareil,
- en ce que la paroi extérieure est composée de plusieurs éléments de paroi formant une surface de paroi fermée, reliés aux structures (10, 12) de parois latérales, et dont au moins un est muni d'un ou de plusieurs connecteurs (30, 32) extérieurs destinés à des branchements extérieurs, les connecteurs (30, 32) étant chacun reliés au moyen d'un dispositif de circuit de transfert (42) à la plage (34, 36) de connecteurs.

2. Paroi arrière d'appareil, caractérisée en ce que les éléments de paroi (18, 20, 22) sont reliés de façon démontable aux structures (10, 12) de parois latérales.

3. Paroi arrière d'appareil selon la revendication 1 ou 2, caractérisée en ce que le dispositif de circuit de transfert comprend une plaque (42) de pontage disposée sensiblement à angle droit sur le côté intérieur d'un élément (18) de paroi, sur le bord (44) d'extrémité dirigé vers la paroi intérieure (6) duquel sont disposés des connecteurs de branchement (34', 36') qui coopèrent avec des connecteurs (34, 36) de la plage, et en ce que sur la plaque (42) de pontage est réalisé un agencement de circuit (46, 60) reliant les connecteurs (34', 36') de branchement aux connecteurs extérieurs (30, 32).

4. Paroi arrière d'appareil selon la revendication 3, caractérisée en ce que les plaques de pontage (42) sont chacune dotée dans chaque cas d'au moins un emplacement d'enfichage destiné à un circuit modulaire susceptible d'être remplacé ou à un groupe de circuits modulaires.

5. Paroi arrière selon l'une des revendications précédentes, caractérisée en ce que sur chacune des plaques (42) de pontage est réalisé un agencement de circuit électronique destiné à la conversion des signaux arrivant aux connecteurs (34, 36) de la plage de connecteurs et à délivrer les signaux convertis aux connecteurs extérieurs (30, 32) des éléments de paroi (18).

6. Paroi arrière d'appareil selon l'une des revendications 1 à 5, caractérisée en ce que le long d'au moins quelques uns des bords des éléments (18) de paroi adjacents aux bords d'éléments de paroi voisins des éléments de blindage (54) sont disposés des éléments d'étanchéité (18, 20) pour réaliser une liaison blindée en haute fréquence.

7. Paroi arrière d'appareil selon la revendication 6, caractérisée en ce que les éléments de blindage (54) sont constitués par des bandes de tôle élastiques disposées parallèlement au bord auquel ils sont affectés de l'élément (18, 20) de paroi et faisant saillie vers l'extérieur au-dessus du bord.

8. Paroi arrière d'appareil selon l'une des revendications 1 à 5, caractérisée en ce que les éléments (18, 20, 22) de paroi individuels sont reliés entre eux de façon électriquement conductrice par l'intermédiaire d'éléments de contact (150) de masse.

9. Paroi arrière d'appareil selon la revendication 8, caractérisée en ce que les éléments de contact (150) de masse sont réalisés sur des surfaces (134) dirigées l'une vers l'autre des éléments (122) de paroi voisins.

10. Paroi arrière d'appareil selon l'une des revendications 1 à 9, caractérisée en ce que les structures (10, 12) de parois latérales forment au moins deux surfaces de support (22, 24) situées sensiblement dans le plan de la paroi extérieure (8) et disposées parallèlement à une certaine distance l'une de l'autre, et sur lesquelles des éléments (18, 20) de paroi juxtaposés par leurs bords longitudinaux sont disposés et fixés par leurs bords transversaux.
